**Europäisches Patentamt**

**European Patent Office**

**Office européen des brevets**

(19)

(11) Veröffentlichungsnummer: **0 274 469**
**B1**

(12) # EUROPÄISCHE PATENTSCHRIFT

(45) Veröffentlichungstag der Patentschrift:
**29.11.89**

(51) Int. Cl.⁴: **H 01 L 27/06, H 01 L 29/08**

(21) Anmeldenummer: **86905191.2**

(22) Anmeldetag: **22.08.86**

(86) Internationale Anmeldenummer:
**PCT/DE 86/00331**

(87) Internationale Veröffentlichungsnummer:
**WO 87/01868 (26.03.87 Gazette 87/7)**

(54) MONOLITHISCH INTEGRIERTE HALBLEITERANORDNUNG.

(30) Priorität: **11.09.85 DE 3532381**

(43) Veröffentlichungstag der Anmeldung:
**20.07.88 Patentblatt 88/29**

(45) Bekanntmachung des Hinweises auf die Patenterteilung:
**29.11.89 Patentblatt 89/48**

(84) Benannte Vertragsstaaten:
**DE FR GB**

(56) Entgegenhaltungen:
**DE-A- 1 564 169**
**FR-A- 1 442 009**
**FR-A- 2 301 923**

**IEEE Transactions on Consumer Electronics, Bd. CE-24, Nr.1, Ferb. 1978, New York (US) F. Bertotti et al.: "New voltage regulators integrate more funktions, have wider application", S. 135-144**

(73) Patentinhaber: **ROBERT BOSCH GMBH, Postfach 50, D-7000 Stuttgart 1 (DE)**

(72) Erfinder: **CONZELMANN, Gerhard, Wilhelmstrasse 37, D-7022 Leinfelden-Echterdingen 1 (DE)**
Erfinder: **NAGEL, Karl, Grundstrasse 24, D-7413 Gomaringen (DE)**

## Beschreibung

### Stand der Technik

Die Erfindung geht aus von einer monolithisch integrierten Halbleiteranordnung nach der Gattung des Hauptanspruches.

Derartige monolithisch integrierte Halbleiteranordnungen sind vielfach bekannt (vgl. z. B. IEEE Transactions on Consumer Electronics, Band CE-24, Nr. 1, Februar 1978, Seiten 135 bis 144), so insbesondere von integrierten Zündungsendstufen von Brennkraftmaschinen und Endstufen von elektrischen Generatorreglern. Zur Schaltung des Stromes und Klammerung der Spannung an induktiven Lasten werden Thyristoren und Freilaufdioden parallel zur induktiven Last geschaltet. In monolithisch integrierter Schaltung bilden diese Leistungsbauelemente zum Substrat hin einen parasitären Transistor, der einen zusätzlichen Substratstrom fliessen lässt. Durch fertigungstechnische Massnahmen lässt sich die Stromverstärkung dieses parasitären Transistors jedoch nur auf typisch kleine Werte zwischen 0,05 und 0,15 einstellen. Dies bedeutet für die Freilaufdiode eines üblichen Drehstromgenerators, der Ströme bis zu 5 Ampere aufnehmen kann, einen parasitären Substratstrom zwischen etwa 0,25 Ampere und 0,75 Ampere.

Bei einem Generator mit 14 Volt Nennspannung, beispielsweise einer Lichtmaschine in einem Kraftfahrzeug, bedeutet dies eine zusätzliche Verlustleistung zwischen 3,5 Watt und 10,5 Watt.

### Vorteile der Erfindung

Die erfindungsgemässe monolithisch integrierte Halbleiteranordnung gemäss dem Anspruch 1 hat demgegenüber den Vorteil, dass die aus dem Stand der Technik bekannte, durch parasitäre Substratströme verursachte Verlustleistung deutlich abgesenkt werden kann. Dies wird durch Erhöhung des Kollektorbahnwiderstandes des parasitären Transistors erreicht, der dadurch bis in die Sättigung gelangen kann.

In den Unteransprüchen sind besonders vorteilhafte und die Erfindung weiterbildende Massnahmen zur Erhöhung des Kollektorbahnwiderstandes des parasitären Transistors angegeben. Eine besonders vorteilhafte Möglichkeit zur Erhöhung des Kollektorbahnwiderstandes wird dadurch erreicht, dass der unterhalb des parasitären Transistors liegende Substratbereich von einer das Substratpotential führenden Leitung isoliert wird, so dass sich ein zusätzlicher horizontaler Substratbahnwiderstand zum Kollektorbahnwiderstand addiert. Bei Substraten mit Rückseitenmetallisierung kann dies bereits dadurch erreicht werden, dass die stromsperrende Wirkung einer Metall-Halbleiter-Sperrschicht ausgenutzt wird. Dies kann aber auch dadurch erreicht werden, dass vor Aufbringen der Rückseitenmetallisierung durch Oxidierung oder Nitridierung der Substratrückseite eine Isolierschicht aufgebracht wird.

### Zeichnung

Ein Ausführungsbeispiel der Erfindung ist in der Zeichnung dargestellt und in der nachfolgenden Beschreibung näher erläutert. Die Figur 1 zeigt ein Prinzipschaltbild einer Leistungsendstufe zur Schaltung einer induktiven Last; Figur 2 zeigt einen Querschnitt eines Teils seiner Struktur; Figur 3 zeigt eine Aufsicht auf die Struktur.

### Beschreibung des Ausführungsbeispieles

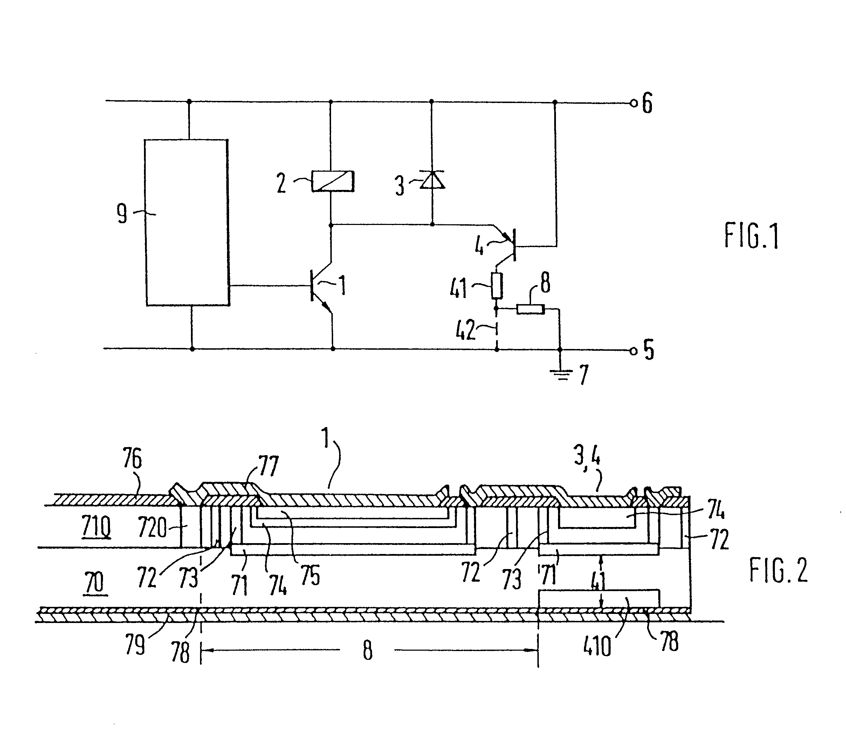

In Figur 1 ist ein npn-Leistungstransistor 1 mit seinem Kollektor an eine induktive Last 2 geschlossen, zu der eine Freilaufdiode 3 parallel geschaltet ist. Die Freilaufdiode 3 bildet gleichzeitig die Emitter-Basis-Diode eines parasitären Transistors 4, der mit seinem Kollektor über einen Kollektorbahnwiderstand 41 zu einem Substratanschluss 42 führt. Mit 5 ist eine erste Versorgungsspannungsklemme und mit 6 eine zweite Versorgungsspannungsklemme bezeichnet. Das Potential an der Versorgungsspannungsklemme 5 stellt die Masse 7 der Schaltungsanordnung dar. Ein zusätzlicher Substratwiderstand 8 ist parallel zum unterbrochenen Substratanschluss 42 geschaltet. Die gesamte Schaltungsanordnung wird von einer Ansteuerschaltung 9 betrieben, die die Basis des Endstufentransistors 1 ansteuert.

Die Funktionsweise der Ansteuerschaltung 9 ist für das Verständnis der Schaltung unerheblich und daher zur Vereinfachung der Darstellung nicht näher erläutert.

In Figur 2 ist ein Schnitt durch eine monolithisch integrierte Schaltung gemäss Figur 1 dargestellt, wobei mit 70 das Substrat und mit 710 eine darauf abgeschiedene Epitaxie bezeichnet ist. In der Mitte der Figur 2 ist der Endstufentransistor 1 zu erkennen. Am rechten Rand ist die Freilaufdiode 3 bzw. der von ihr zusammen mit dem Substrat gebildete parasitäre Transistor 4 zu erkennen. Der Endstufentransistor 1 ist als Vertikaltransistor mit einer vergrabenen Kollektorschicht 71 ausgebildet. Eine Isolierungsdiffusion 72 bildet gleichzeitig einen Anschluss für das Substratpotential. Mit 73 ist der Kollektor, mit 74 ist die Basis und mit 75 ist der Emitter des Endstufentransistors 1 bezeichnet. Die dargestellte monolithisch integrierte Schaltung ist in bekannter Weise mit einer als Isolierung dienenden Oxidschicht 76 belegt, dazwischen und darüber ist eine metallische Verbindung 77 erkennbar, die die elektrischen Verbindungen zwischen den einzelnen Elementen der Halbleiteranordnung herstellt. Die Rückseite des dargestellten Teiles des Substrates ist mit einer Isolierschicht 78 überzogen, über die eine Rückseitenmetallisierung 79 gelegt ist.

Die Freilaufdiode 3 wird mit dem Endstufentransistor 1 im gleichen Herstellungsprozess auf dem Substrat gebildet. Ihre Diffusionszonen sind daher in Figur 2 mit den gleichen Bezugzeichen dargestellt, wie sie beim Endstufentransistor 1 in Erscheinung treten. Unterhalb der Freilaufdiode 3 ist zusätzlich eine Widerstandsdiffusion 410 von der Rückseite des Substrates her eingebracht worden.

Der in Figur 1 dargestellte Kollektorbahnwiderstand 41 ist auch in Figur 2 angedeutet, wie er dort nach dem Stand der Technik vorliegen würde, wenn keine Widerstandsdiffusion 410 und keine Isolierschicht 78 vorhanden wären. Dementsprechend ist in Figur 1 der Substratanschluss 42 auch unterbrochen dargestellt, so dass der Kollektorstrom des parasitären Transistors 4 über den zusätzlich gebildeten Substratwiderstand 8 fliessen muss, wodurch der Kollektorstrom vermindert und der parasitäre Transistor 4 in Sättigung gebracht wird. Hierzu fliesst der Strom von der Anode der Freilaufdiode 3 bzw. dem Emitter des parasitären Transistors 4 über seinen Kollektor und eine unter dem Endstufentransistor 1 liegende Substratstrecke, die den zusätzlichen Substratwiderstand 8 bildet, zur als Potentialanschluss dienenden Isolierungsdiffusion 720.

Auf die in Figur 2 dargestellte Isolierschicht 78 kann verzichtet werden, wenn keine hohen Anforderungen an die Isolierwirkung gestellt werden. Dann kann nämlich der gesperrte Halbleiter-Metall-Übergang zur Isolation benutzt werden. Die Widerstandsdiffusion 410 erhöht zusätzlich den Kollektorbahnwiderstand, da von der Substratrückseite her kompensierende und die Trägerlebensdauer absenkende Dotierungssubstanzen eingebracht werden.

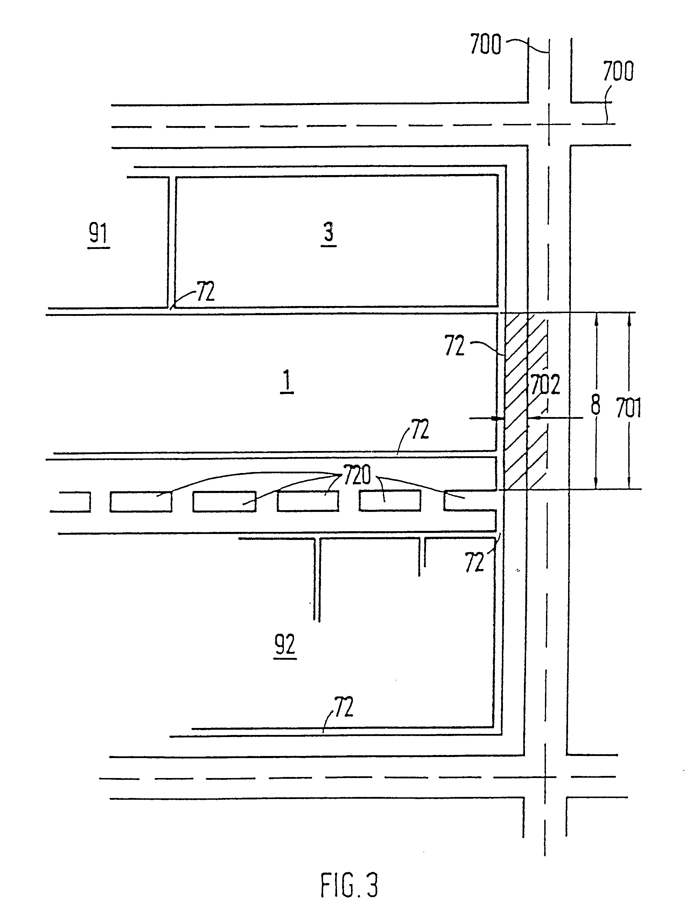

In der in Figur 3 dargestellten Aufsicht der monolithisch integrierten Schaltung sind mit 700 die in der Mitte des Ritzrahmens liegenden Trennlinien bezeichnet, an denen nach dem Ende der Diffusionsprozesse die einzelnen Chips aus dem Wafer gebrochen werden. Mit 1 ist der Bereich des Endstufentransistors bezeichnet, mit 3 der Bereich der Freilaufdiode. Die Ansteuerschaltung ist in einen Teil 91, der unempfindlich ist gegen eine Anhebung des Substratpotentials und deswegen unmittelbar neben der Freilaufdiode 3 angeordnet werden kann, und in einen Teil 92 auf der anderen Seite der als Barriere wirkenden Isolierungsdiffusion 72 aufgeteilt. Der in einem Abschnitt 701 verlaufende Anteil der Isolierungsdiffusion 72 bildet einen Nebenschluss zum Substrat; er ist deshalb so eng wie möglich auszuführen. Weiterhin sollte der äussere Chiprand 702 mindestens über die Länge des Abschnittes 701 von Dotierungssubstanzen freigehalten werden. Diese Dotierungssubstanzen könnten sonst den Substratwiderstand absenken oder sogar die durch die Isolierungsdiffusion 72 gebildete Barriere wenigstens teilweise unwirksam machen.

## Patentansprüche

1. Monolithisch integrierte Halbleiteranordnung mit wenigstens einer Leistungsdiode (3), die an der mit einer Epitaxialschicht (710) versehenen Vorderseite eines Substrats (70) ausgebildet ist, deren Kathode auf einem Potential liegt, das höher als das Potential des Substrats ist, und deren Anode den Emitter und deren Kathode die Basis eines parasitären Transistors (4) bilden, dessen Kollektor durch das Substrat gebildet wird, dadurch gekennzeichnet, dass zur Erniedrigung des Kollektorstroms des parasitären Transistors (4) dessen Kollektorbahnwiderstand (41) um einen zusätzlichen Substratwiderstandsanteil (8) erhöht ist, der durch einen sich horizontal über die Leistungsdiode (3) hinaus erstreckenden Bereich aus Substratmaterial gebildet ist, wobei Mittel (78, 720, 77) vorgesehen sind, die bewirken, dass der Kollektorstrom des parasitären Transistors (4) auch über den zusätzlichen Substratwiderstandsanteil (8) fliesst.

2. Monolithisch integrierte Halbleiteranordnung nach Anspruch 1, dadurch gekennzeichnet, dass das Substrat (70) in dem von der Leistungsdiode (3) beanspruchten und in dem sich über die Leistungsdiode (3) hinaus erstreckenden, den zusätzlichen Substratwiderstandsanteil (8) bildenden Bereich des Kollektorbahnwiderstandes des parasitären Transistors (4) gegenüber einer auf Massepotential liegenden Gegenelektrode (79), die an der Rückseite des Substrats (70) angebracht ist, elektrisch isoliert ist.

3. Monolithisch integrierte Halbleiteranordnung nach Anspruch 1, dadruch gekennzeichnet, dass das Substrat (70) mindestens in dem von der Leistungsdiode (3) beanspruchten und in dem sich über die Leistungsdiode (3) hinaus erstreckenden, den zusätzlichen Substratwiderstandsanteil (8) bildenden Bereich des Kollektorbahnwiderstandes des parasitären Transistors (4) gegenüber einer auf Massepotential liegenden Gegenelektrode (79), die an der Rückseite des Substrats (70) angebracht ist, elektrisch isoliert ist, und dass das Substrat (70) an dem der Leistungsdiode (3) abgewandten Ende des sich über die Leistungsdiode (3) hinaus erstreckenden, den zusätzlichen Substratwiderstandsanteil (8) bildenden Bereichs des Kollektorbahnwiderstandes des parasitären Transistors (4) über mindestens eine sich durch die Epitaxialschicht (710) hindurch erstreckende Isolierungsdiffusionszone (720) an eine Massepotential führende Metallisierung (77) angeschlossen ist.

4. Monolithisch integrierte Halbleiteranordnung nach Anspruch 2 oder 3, dadurch gekennzeichnet, dass die Gegenelektrode (79) durch eine Metallisierung gebildet ist.

5. Monolithisch integrierte Halbleiteranordnung nach einem der Ansprüche 2 bis 4, dadurch gekennzeichnet, dass die Isolierung durch eine Metall-Halbleiter-Sperrschicht gebildet ist.

6. Monolithisch integrierte Halbleiteranordnung nach einem der Ansprüche 2 bis 4, dadurch gekennzeichnet, dass die Isolierung durch eine zwischen der Gegenelektrode (79) und dem Substrat (70) liegende Isolierschicht (78), vorzugsweise durch eine Oxid- oder Nitridisolierschicht, gebildet ist.

7. Monolithisch integrierte Halbleiteranordnung nach einem der Ansprüche 1 bis 6, bei der der den Kollektorbahnwiderstand (8, 41) des parasitären Transistors (4) bildende Bereich des Substrats (70) bis in die Nähe des Randes der monolithisch integrierten Halbleiteranordnung geführt ist, dadurch gekennzeichnet, dass der Randbereich der monolithisch integrierten Halbleiteranordnung mindestens über diejenige Länge, entlang der der Kollektorbahnwiderstand (8, 41) des parasitären Transistors (4) an ihn angrenzt, von Substanzen freigehalten ist, die den Widerstandswert reduzieren.

8. Monolithisch integrierte Halbleiteranordnung nach einem der Ansprüche 1 bis 7, dadurch gekennzeichnet, dass über dem durch das Substrat (70) gebildeten zusätzlichen Kollektorbahnwiderstandsanteil (8) mindestens eine weitere Komponente der monolithisch integrierten Halbleiteranordnung, insbesondere ein Leistungstransistor (1), angeordnet ist.

## Revendications

1. Agencement semi-conducteur à intégration monolithique comportant au moins une diode de puissance (3) qui est formée sur un substrat (70) muni de son côté antérieur d'une couche épitaxiale (710) dont la cathode est à un potentiel plus élevé que celui du substrat, et dont l'anode forme l'émetteur et la cathode la base d'un transistor parasite (4) dont le collecteur est formé par le substrat, caractérisé en ce que, pour l'affaiblissement du courant de collecteur du transistor parasite (4), la résistance de piste de collecteur (41) est élevée autour d'un élément de résistance additionnelle du substrat (8) qui est formé par une zone de la matière du substrat s'étendant horizontalement sur la diode de puissance (3), où sont prévus des moyens (78, 720, 77) qui agissent de sorte que le courant de collecteur du transistor parasite (4) s'écoule aussi sur l'élément de résistance additionnelle du substrat (8).

2. Agencement semi-conducteur intégré monolithique selon la revendication 1, caractérisé en ce que le substrat (70) sollicité par la diode de puissance (3), et dans lequel la zone de la résistance de piste de collecteur du transistor parasite (4) formant la résistance additionnelle de substrat (8) s'étendant vers l'extérieur sur la diode de puissance (3), par rapport à une contre-électrode (79) se trouvant au potentiel de la masse qui est apportée sur le dos du substrat (70), est isolé électriquement.

3. Agencement semi-conducteur intégré monolithique selon la revendication 1, caractérisé en ce que le substrat (70) au moins dans la zone formant la partie de résistance de piste du collecteur du transistor parasite (4) sollicitée par la diode de puissance (3) s'étendant vers l'extérieur sur la diode de puissance (3) est appliqué contre une contre-électrode (79) se trouvant au potentiel de la masse, est isolé électriquement, et en ce que le substrat (70) sur l'extrémité faisant face au côté arrière s'étendant vers l'extérieur sur la diode de puissance (3) et en ce que le substrat (70) sur lequel l'extrémité de la zone de la résistance de piste du collecteur du transistor parasite (4) faisant face à la diode de puissance (3) formant l'élément de résistance additionnelle du substrat (8) est liée à une métallisation (77) conduisant à un potentiel de masse sur au moins une zone de diffusion isolante (720) s'étendant vers l'intérieur à travers la couche épitaxiale (710).

4. Agencement semi-conducteur intégré monolithique selon la revendication 2 ou 3, caractérisé en ce que la contre-électrode (79) est formée d'une métallisation.

5. Agencement semi-conducteur intégré monolithique selon l'une des revendications 2 à 4, caractérisé en ce que l'isolation est réalisée par une couche barrière métal - semi-conducteur.

6. Agencement semi-conducteur intégré monolithique selon l'une des revendications 2 à 4, caractérisé en ce que l'isolation par une couche isolante (78) se trouvant entre la contre-électrode (79) et le substrat (70) est formée avantageusement d'une couche isolante d'oxyde ou de nitrure.

7. Agencement semi-conducteur intégré monolithique selon l'une des revendications 1 à 6, sur la zone du substrat (70) formant la résistance de piste de collecteur (8, 41) du transistor parasite (4) est conduit jusqu'au voisinage de la bordure du dispositif à semi-conducteur intégré monolithique, caractérisé en ce que la zone de bordure du dispositif à semi-conducteur intégré monolithique est limitée au moins sur ces longueurs le long desquelles se limite la résistance de piste de collecteur (8, 41) du transistor parasite (4) est maintenue exempte de substances qui réduiraient la valeur de la résistance.

8. Agencement semi-conducteur intégré monolithique selon l'une des revendications 1 à 7, caractérisé en ce que, sur l'élément de résistance de piste de collecteur (8) formé par le substrat (70), est placé au moins un autre composant du dispositif à semi-conducteur intégré monolithique, en particulier un transistor de puissance (1).

## Claims

1. Monolithically-integrated semiconductor devices comprising at least one power diode (3) which is formed at the front of a substrate (70) which is provided with an epitaxial layer (710), the cathode of which is at a potential which is higher than the potential of the substrate and the anode of which forms the emitter and its cathode forms the base of a parasitic transistor (4) the collector of which is formed by the substrate, characterized in that, for the purpose of lowering the collector current of the parasitic transistor (4), its collector path resistance (41) is increased by an additional substrate resistance component (8) which is formed by a region of substrate material which extends horizontally past the power diode (3), means (78, 720, 77) being provided which have the effect that the collector current of the parasitic transistor (4) also flows via the additional substrate resistance component (8).

2. Monolithically-integrated semiconductor devices according to Claim 1, characterized in that the substrate (70) is electrically insulated with respect to a counter electrode (79), which is at earth potential and which is attached to the reverse side of the substrate (70), in the area of the collector path resistance of the parasitic transistor (4) claimed by the power diode (3), and in that extending past the power diode (3) and forming the additional substrate resistance component (8).

3. Monolithically-integrated semiconductor devices according to Claim 1, characterized in that the substrate (70) is electrically insulated with respect to a counter electrode (79) which is at earth potential and which is attached to the reverse side of the substrate (70), at least in the area of the collector path resistance of the parasitic transistor (4) claimed by the power diode (3), and in that extending past the power diode (3) and forming the additional substrate resistance component (8), and in that the substrate (70) is connected to an earth-potential carrying metallization (77) over at least an isolation diffusion zone (720) extending through the epitaxial layer (710) at the end facing away from the power diode (3) of the area of the collector path resistance of the parasitic transistor (4) extending past the power diode (3) and forming the additional substrate resistance component (8).

4. Monolithically-integrated semiconductor devices according to Claim 2 or 3, characterized in that the counter electrode (79) is formed by a metallization.

5. Monolithically-integrated semiconductor devices according to one of Claims 2 to 4, characterized in that the insulation is formed by a metal-semiconductor barrier layer.

6. Monolithically-integrated semiconductor devices according to one of Claims 2 to 4, characterized in that the insulation by an insulating layer (78) located between the counter electrode (79) and the substrate (70) is preferably formed by an oxide or nitride insulation layer.

7. Monolithically-integrated semiconductor devices according to one of Claims 1 to 6, in which the area of the substrate (70) forming the collector path resistance (8, 41) of the parasitic transistor (4) is carried to the vicinity of the edge of the monolithically-integrated semiconductor devices, characterized in that the edge region of the monolithically-integrated semiconductor devices is kept free of substances reducing the resistance value at least over the length along which the collector path resistance (8, 41) of the parasitic transistor (4) adjoins it.

8. Monolithically-integrated semiconductor devices according to one of Claims 1 to 7, characterized in that at least one further component of the monolithically-integrated semiconductor devices, in particular a power transistor (1), is arranged above the additional collector path resistance component (8) formed by the substrate (70).

FIG.1

FIG.2

FIG. 3